# EUROPEAN PATENT APPLICATION

(11) **EP 4 723 151 A1**
(43) Date of publication of application: **08.04.2026**
(21) Application number: 25203565.4
(22) Date of filing: 22.09.2025
(51) Int. Cl.: H01G 4/08, G02B 26/08, H01G 4/14, H01G 4/30, H01G 13/00, C23C 14/04

(54) **APPARATUS FOR MAKING A MULTI-LAYER CAPACITIVE DEVICE USING A MICRO-ELECTROMECHANICAL SYSTEM (MEMS) DEVICE AND RELATED METHODS**

(30) Priority: 03.10.2024 US 202418906015
(71) Applicant: Eagle Technology, LLC, Melbourne, FL 32919 (US)
(72) Inventor: RAUSCHER, Scott, Fairfax 22033 (US); BAUER, Matthew J., Melbourne 32901 (US); RENDEK JR., Louis J., Melbourne 32940 (US); Jason THOMPSON, Jason, Melbourne 32904 (US)
(74) Representative: Schmidt, Steffen J.

(57) **Abstract**

An apparatus **20** for making a multi-layer capacitive device **40** may include a deposition chamber **21** and a conductive material source **22** within the deposition chamber. The apparatus **20** may also include a dielectric material source **23** within the deposition chamber **21** and a micro-electromechanical system (MEMS) deposition shadow mask **30** within the deposition chamber. The apparatus **20** may also include a controller **35** outside the deposition chamber **21** and configured to selectively operate the conductive material source **22** and the dielectric material source **23** and operate the MEMS deposition shadow mask **30** adjacent a substrate **25** within the deposition chamber to selectively deposit alternating conductive material and dielectric material layers onto the substrate to make the multi-layer capacitive device **40.**

## Description

### Technical Field

The present invention relates to the field of electronics, and, more particularly, to multi-layer capacitive device fabrication, and related methods.

### Background

A capacitor is a device that stores electrical energy by accumulating electric charges on two closely spaced conductive surfaces that are electrically insulated from each other. More particularly, a capacitor may include two spaced apart electrically conductive layers. The spaced apart electrically conductive layers are spaced apart from each other by way of a dielectric material layer. A capacitor may be embodied in different forms, for example, with respect to internal construction (e.g., materials) and physical appearance.

One type of capacitor is a multi-layer capacitor, for example, a multi-layer ceramic capacitor. A multi-layer capacitor may include two or more alternating layers of ceramic and metal in which the ceramic material acts as the dielectric and the metal acts as the electrodes. The electrodes of a multi-layer ceramic capacitor, for example, are deposited on a ceramic layer by metallization. Alternating metallized ceramic layers are stacked one above the other. The metallization of the electrodes at opposing sides may be coupled via a terminal.

### Summary

An apparatus for making a multi-layer capacitive device may include a deposition chamber and a conductive material source within the deposition chamber. The apparatus may also include a dielectric material source within the deposition chamber and a micro-electromechanical system (MEMS) deposition shadow mask within the deposition chamber. The apparatus may also include a controller outside the deposition chamber and configured to selectively operate the conductive material source and the dielectric material source and operate the MEMS deposition shadow mask adjacent a substrate within the deposition chamber to selectively deposit alternating conductive material and dielectric material layers onto the substrate to make the multi-layer capacitive device.

The MEMS deposition shadow mask may include a deposition mask and at least one MEMS actuator device coupled thereto. The controller may be configured to operate the at least one MEMS actuator device to reposition the deposition mask between successive layers, for example. The controller may be configured to operate the at least one MEMS actuator device to reposition the deposition mask so that successive conductive material layers are laterally offset. The controller may be configured to selectively operate the conductive material source and the dielectric material source and operate the MEMS deposition shadow mask to define terminals on the substrate for the multi-layer capacitive device.

The deposition chamber may include a semiconductor deposition chamber, and the substrate may include a semiconductor substrate, for example. The semiconductor substrate may include a silicon substrate. The deposition chamber may include one of a chemical vapor deposition chamber, a physical vapor deposition chamber, and an atomic layer deposition chamber, for example.

A method aspect is directed to a method of making a multi-layer capacitive device. The method may include using a controller outside the deposition chamber to selectively operate a conductive material source and a dielectric material source and operate a MEMS deposition shadow mask adjacent a substrate within the deposition chamber to selectively deposit alternating conductive material and dielectric material layers onto the substrate to make the multi-layer capacitive device.

### Brief Description of the Drawings

FIG. 1 is a schematic diagram of an apparatus for making a multi-layer capacitive device in accordance with an embodiment.
FIG. 2A is a schematic diagram illustrating deposition of conductive and dielectric material layers in a first position of the MEMS deposition shadow mask using the apparatus of FIG. 1
FIG. 2B is a schematic diagram illustrating deposition of conductive and dielectric material layers in a second position of the MEMS deposition shadow mask using the apparatus of FIG. 1.
FIG. 3A is a schematic diagram illustrating deposition of multiple layers of a multi-layer capacitive device using the apparatus of FIG. 1.
FIG. 3B is another schematic diagram illustrating deposition of additional multiple layers of a multi-layer capacitive device of FIG. 2A.
FIG. 4 is a schematic diagram of the multi-layer capacitive device made in FIGS. 3A and 3B.

### Detailed Description

The present invention will now be described more fully hereinafter with reference to the accompanying drawings, in which preferred embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. Like numbers refer to like elements throughout.

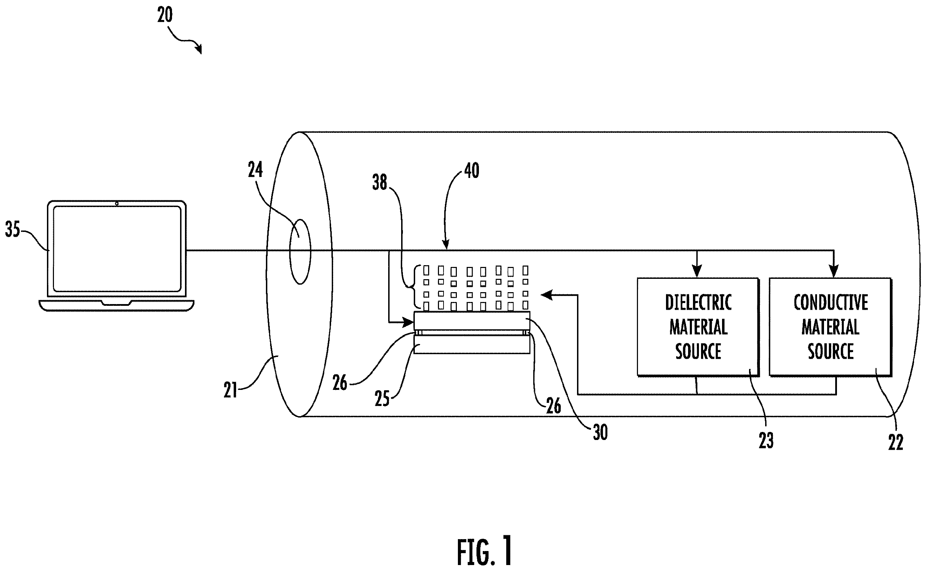

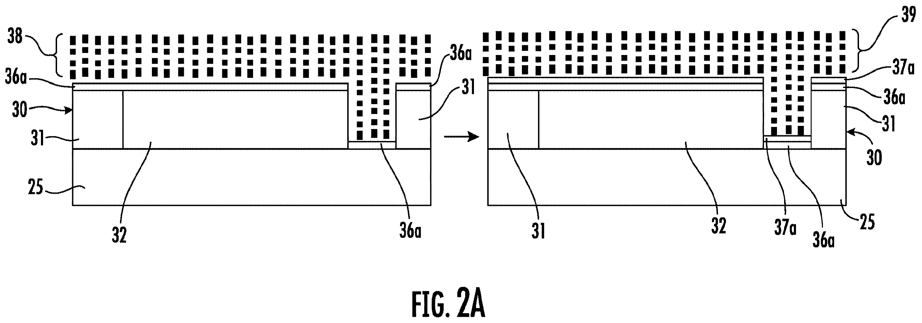

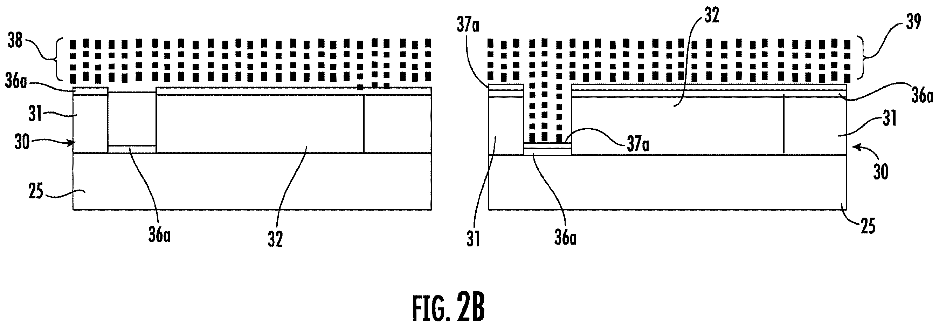

Referring initially to FIGS. 1, 2A, and 2B, an apparatus **20** for making a multi-layer capacitive device **40** is now described. The apparatus **20** includes a deposition chamber **21.** The deposition chamber **21** may be any one of a chemical vapor deposition chamber, a physical vapor deposition chamber, and an atomic deposition chamber, for example. The deposition chamber **21** may be another type of deposition chamber, as will be appreciated by those skilled in the art.

The apparatus **20** also includes a conductive material source **22.** The conductive material source **22** may be a metal source, for example. The apparatus **20** also includes a dielectric material source **23.** The dielectric material source **23** may be silicon oxide source, silicon nitride source, alumina source, or other high-K dielectric material source.

A micro-electromechanical (MEMS) deposition shadow mask **30** is within the deposition chamber **21.** The MEMS deposition shadow mask **30** may include a deposition mask **31** and MEMS actuator devices **32** (e.g., MEMS switches, active MEMS) coupled to or carried by the deposition mask. The deposition mask **31** may be a silicon deposition mask, for example. The MEMS actuator devices **32** may be thermal MEMS or electrostatic MEMS actuator devices, for example.

A controller **35** is outside the deposition chamber **21.** The controller **35** may be in the form of computer, for example, a personal computer, laptop computer, or tablet computer. The controller **35** may include circuitry, for example, an integrated circuit (IC), and/or may be part of another device.

The controller **35** is coupled to the MEMS deposition shadow mask **30.** More particularly, the controller **35** may be coupled to the MEMS deposition shadow mask **30** by way of a wired connection **36** that passes through an electrical feedthrough **24** in the deposition chamber **21.**

The controller **35** selectively operates the conductive material source **22** and the dielectric material source **23,** and the MEMS deposition shadow mask **30.** The controller **35** operates the MEMS deposition shadow mask **30** adjacent a substrate **25** within the deposition chamber **21.** The substrate **25** may be a semiconductor substrate, and more particularly, a silicon substrate, for example. The substrate **25** may be another or include other and/or additional substrate materials, as will be appreciated by those skilled in the art. In an embodiment, a shim or stand-off **26** may be included between the MEMS deposition shadow mask **30** and the substrate **25.**

The controller **35** selectively operates the MEMS deposition shadow mask **30** to selectively deposit alternating conductive material and dielectric material layers **36a, 37a** onto the substrate **25** to make the multi-layer capacitive device. More particularly, the controller **35** may operate the MEMS actuator devices **32** to reposition the deposition mask **31** between successive conductive material and dielectric material layers **36a, 37a.** Illustratively, the MEMS deposition shadow mask **30** is positioned in a first position (FIG. 2A), and the conductive material and dielectric material layers **36a, 37a** are deposited with a conductive material deposition **38** and a dielectric material deposition **39,** respectively. Alternatively, the MEMS deposition shadow mask **30** may be positioned (or repositioned for successive layers as will be described in further detail below) in a second position (FIG. 2B) and the conductive material and dielectric material layers **36a, 37a** are deposited with a conductive material deposition **38** and a dielectric material deposition **39,** respectively. As will be appreciated by those skilled in the art, it may not be desirable to charge the substrate **25** for adherence.

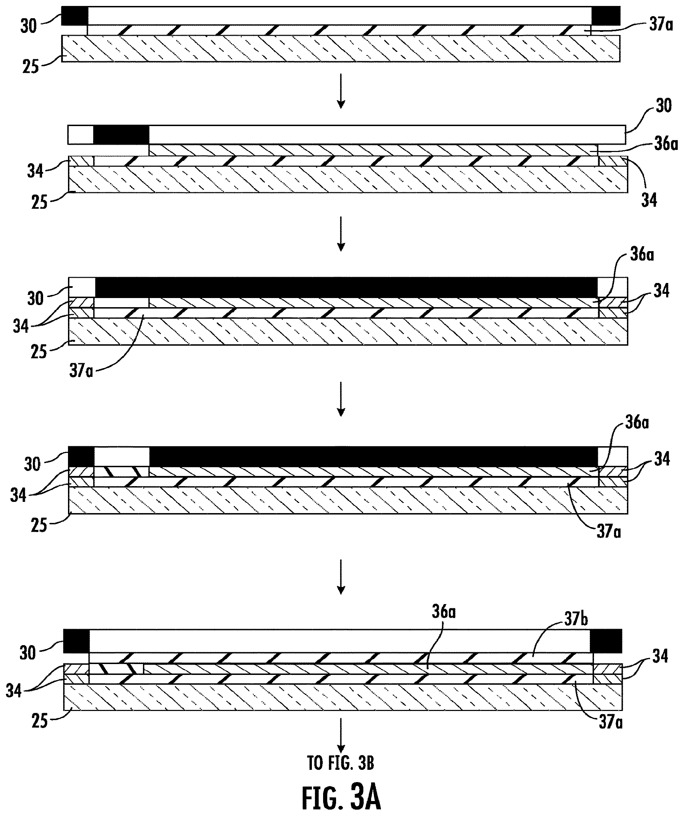

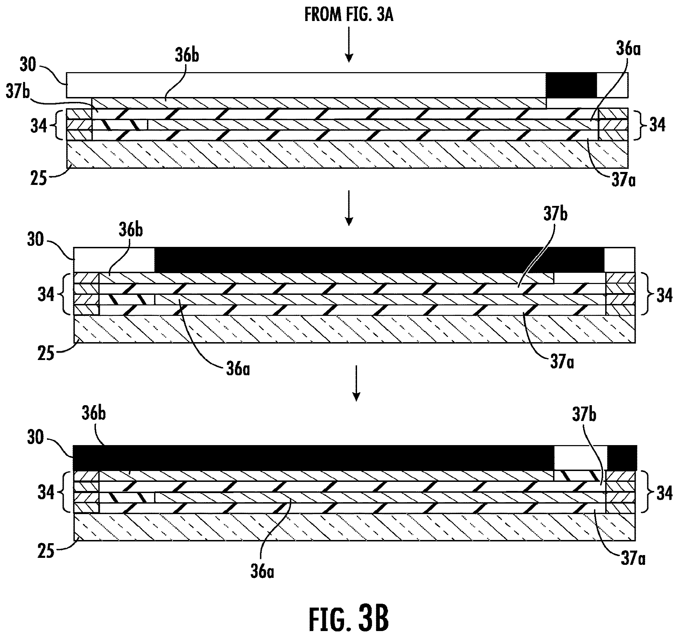

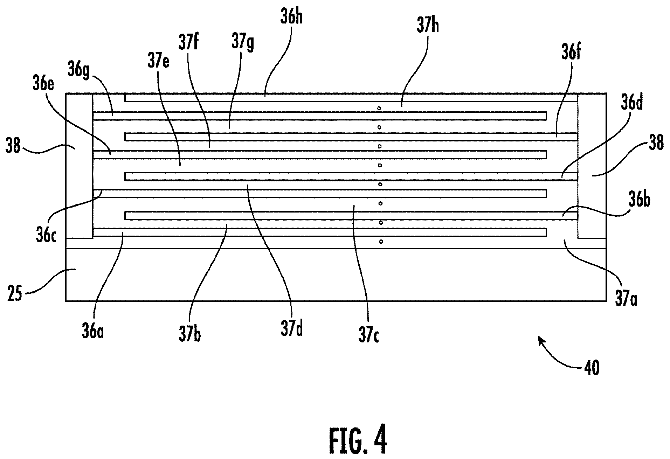

Referring additionally to FIGS. 3A, 3B, and 4, a multi-layer capacitive device **40** with eight conductive material layers **36a-36h** is illustrated (FIG. 4). The controller **35** selectively operates the conductive material source **22** and the dielectric material source **23,** and the MEMS deposition shadow mask **30** for each layer. (FIGS. 3A and 3B). For example, the MEMS deposition shadow mask **30** is positioned over the substate **25** as illustrated, and a dielectric material layer **37a** is deposited. The MEMS deposition shadow mask **30** is repositioned, for example, by selective operation of the MEMS actuator devices **32,** and a conductive material layer **36a** is applied. The MEMS deposition shadow mask **30** is again repositioned, for example, by selective operation of the MEMS actuator devices **32** so that a successive dielectric material and conductive material layer pair **37b, 36b** (i.e., the second layer) is deposited upon the first layer. The MEMS deposition shadow mask **30** is repositioned for each successive dielectric material and conductive material layer pair **37c-37h, 36c-36h,** thus defining the layers of the multi-layer capacitive device **40.** Illustratively, the MEMS actuator devices **32** are repositioned so that successive conductive material layers **36a-36h** are laterally offset. In this way, one or more electrodes or terminals **34** may be defined on the substrate **25** for the multi-layer capacitive device **40.**

Accordingly, the apparatus **20** may make the multi-layer capacitive device **40** to have a number of layers to define a device thickness in the range of 50-1000 microns, for example. Moreover, the apparatus **20,** through control of the MEMS deposition shadow mask **30,** may advantageously permit altering of the shadow mask pattern on the substrate **25** or target wafer ad-hoc during deposition without breaking vacuum of the deposition chamber **21.**

A method aspect is directed to a method of making a multi-layer capacitive device **40.** The method includes using a controller **35** outside the deposition chamber **21** and configured to selectively operate a conductive material source **22** and a dielectric material source **23** and operate a MEMS deposition shadow mask **30** adjacent a substrate **25** within the deposition chamber to selectively deposit alternating conductive material **36a** and dielectric material layers **37a** onto the substrate to make the multi-layer capacitive device **40.**

While several embodiments have been described herein, it should be appreciated by those skilled in the art that any element or elements from one or more embodiments may be used with any other element or elements from any other embodiment or embodiments. Many modifications and other embodiments of the invention will come to the mind of one skilled in the art having the benefit of the teachings presented in the foregoing descriptions and the associated drawings. Therefore, it is understood that the invention is not to be limited to the specific embodiments disclosed, and that modifications and embodiments are intended to be included within the scope of the appended claims.

## Claims

1. An apparatus for making a multi-layer capacitive device comprising:
a deposition chamber;
a conductive material source within the deposition chamber;
a dielectric material source within the deposition chamber;
a micro-electromechanical system (MEMS) deposition shadow mask within the deposition chamber; and
a controller outside the deposition chamber and configured to selectively operate the conductive material source and the dielectric material source and operate the MEMS deposition shadow mask adjacent a substrate within the deposition chamber to selectively deposit alternating conductive material and dielectric material layers onto the substrate to make the multi-layer capacitive device.

2. The apparatus of Claim 1 wherein the MEMS deposition shadow mask comprises a deposition mask and at least one MEMS actuator device coupled thereto.

3. The apparatus of Claim 2 wherein the controller is configured to operate the at least one MEMS actuator device to reposition the deposition mask between successive layers.

4. The apparatus of Claim 2 wherein the controller is configured to operate the at least one MEMS actuator device to reposition the deposition mask so that successive conductive material layers are laterally offset.

5. The apparatus of Claim 1 wherein the controller is configured to selectively operate the conductive material source and the dielectric material source and operate the MEMS deposition shadow mask to define terminals on the substrate for the multi-layer capacitive device.

6. A method of making a multi-layer capacitive device comprising:
using a controller outside a deposition chamber to selectively operate a conductive material source and a dielectric material source and operate a MEMS deposition shadow mask adjacent a substrate within the deposition chamber to selectively deposit alternating conductive material and dielectric material layers onto the substrate to make the multi-layer capacitive device.

7. The method of Claim 6 wherein the MEMS deposition shadow mask comprises a deposition mask and at least one MEMS actuator device coupled thereto.

8. The method of Claim 7 wherein using the controller comprises using the controller to operate the at least one MEMS actuator device to reposition the deposition mask between successive layers.

9. The method of Claim 7 wherein using the controller comprises using the controller to operate the at least one MEMS actuator device to reposition the deposition mask so that successive conductive material layers are laterally offset.

10. The method of Claim 6 wherein using the controller comprises using the controller to selectively operate the conductive material source and the dielectric material source and operate the MEMS deposition shadow mask to define terminals on the substrate for the multi-layer capacitive device.
